# EUROPEAN PATENT APPLICATION

(11) **EP 4 418 840 A1**
(43) Date of publication of application: **21.08.2024**
(21) Application number: 23845297.3
(22) Date of filing: 07.07.2023
(51) Int. Cl.: H10K 59/35, H10K 50/822, H10K 59/12

(54) **DISPLAY SUBSTRATE AND DISPLAY DEVICE**

(30) Priority: 27.07.2022 CN 202210893282
(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: HUO, Baolei, Beijing 100176 (CN); WANG, Yang, Beijing 100176 (CN); ZHOU, Qiang, Beijing 100176 (CN); MOU, Xin, Beijing 100176 (CN); GAO, Feifei, Beijing 100176 (CN); ZHANG, Hanxiao, Beijing 100176 (CN)
(74) Representative: Durán-Corretjer, S.L.P.
(86) International application number: PCT/CN2023/106348
(87) International publication number: WO 2024/022084

(57) **Abstract**

A display substrate, comprising: a base, a plurality of first pixel units located on the base in a first display region, and a plurality of second pixel units located on the base in a second display region. A first light-emitting element comprised in each first pixel unit comprises a first anode, a first organic light-emitting structure, and a first cathode which are sequentially arranged in the direction away from the base. The first cathode is provided with a plurality of first openings, and the orthographic projections of the first openings on the base do not overlap the orthographic projection of a light-emitting region of the first light-emitting element on the base. A second light-emitting element comprised in each second pixel unit comprises a second anode, a second organic light-emitting structure, and a second cathode which are sequentially arranged in the direction away from the base. The sum of the areas of the light-emitting regions of the first light-emitting elements in the first display region is less than the sum of the areas of the light-emitting regions of the second light-emitting elements in the second display region.

## Description

The present application claims priority to Chinese Patent Application No. 202210893282.7, entitled "Display Substrate and Display Device" and filed to the China National Intellectual Property Administration on July 27, 2022, contents of which should be regarded as being incorporated herein by reference.

### Technical Field

The present disclosure relates to, but is not limited to, the field of display technologies, in particular to a display substrate and a display apparatus.

### Background

An Organic Light Emitting Diode (OLED) and a Quantum dot Light Emitting Diode (QLED) are active light emitting display devices and have advantages of self-illumination, a wide viewing angle, a high contrast ratio, low power consumption, an extremely high reaction speed, lightness and thinness, bendability, and a low cost, etc.

### Summary

The following is a summary of subject matters described herein in detail. The summary is not intended to limit the scope of protection of claims.

Embodiments of the present disclosure provide a display substrate and a display apparatus.

In one aspect, an embodiment provides a display substrate, which includes a base substrate, a plurality of first pixel units, and a plurality of second pixel units. The base substrate includes a first display region and a second display region located on at least one side of the first display region. The plurality of first pixel units are located in the first display region. A first pixel unit includes a plurality of first light emitting elements, and a first light emitting element includes a first anode, a first organic light emitting structure, and a first cathode disposed sequentially along a direction away from the base substrate. The first cathode has a plurality of first openings, and orthographic projections of the first openings on the base substrate are not overlapped with an orthographic projection of a light emitting region of the first light emitting element on the base substrate. The plurality of second pixel units are located in the second display region. A second pixel unit includes a plurality of second light emitting elements, wherein a second light emitting element includes a second anode, a second organic light emitting structure, and a second cathode disposed sequentially along the direction away from the base substrate. A sum of areas of light emitting regions of first light emitting elements of the first display region is less than a sum of areas of light emitting regions of second light emitting elements of the second display region.

In some exemplary implementation modes, a spacing between at least one first light emitting element and an adjacent first light emitting element within at least one of the plurality of first pixel units is less than a spacing between the first light emitting element and an adjacent first light emitting element within at least one adjacent first pixel unit.

In some exemplary implementation modes, at least one first pixel unit shares at least one first light emitting element with an adjacent first pixel unit.

In some exemplary implementation modes, at least one first pixel unit includes only a plurality of first light emitting elements emitting light of different colors.

In some exemplary implementation modes, a first organic light emitting structure of at least one first light emitting element includes at least a plurality of emitting layers stacked, wherein a connection unit is disposed between adjacent emitting layers.

In some exemplary implementation modes, a post spacer is disposed around the first light emitting element, and the connection unit is disconnected at a position of the post spacer.

In some exemplary implementation modes, the first openings are located between adjacent first pixel units.

In some exemplary implementation modes, the second cathode and the first cathode are of an integral structure.

In some exemplary implementation modes, a pixel center of at least one first pixel unit is different from a pixel center of the second pixel unit.

In some exemplary implementation modes, a spacing between at least one first light emitting element and an adjacent first light emitting element within at least one first pixel unit is less than a spacing between at least one second light emitting element and an adjacent second light emitting element within the second pixel unit; the first light emitting element and the second light emitting element emit light of a same color.

In some exemplary implementation modes, the first pixel unit includes one first light emitting element emitting light of a first color, one first light emitting element emitting light of a second color, and two first light emitting elements emitting light of a third color, and the four first light emitting elements included in the first pixel unit are arranged in a shape of a diamond. The second pixel unit includes one second light emitting element emitting light of the first color, one second light emitting element emitting light of the second color, and two second light emitting elements emitting light of the third color; and the four second light emitting elements included in the second pixel unit are arranged in a shape of a diamond. A spacing between the first light emitting element emitting the light of the second color and an adjacent first light emitting element emitting light of the first color within the first pixel unit is less than a spacing between the second light emitting element emitting the light of the second color and an adjacent second light emitting element emitting light of the first color within the second pixel unit.

In some exemplary implementation modes, a quantity of first light emitting elements included in the first pixel unit is different from a quantity of second light emitting elements included in the second pixel unit.

In some exemplary implementation modes, the quantity of first light emitting elements included in the first pixel unit is less than the quantity of second light emitting elements included in the second pixel unit.

In some exemplary implementation modes, the first pixel unit includes one first light emitting element that emits light of a first color, one first light emitting element that emits light of a second color, and one first light emitting element that emits light of a third color. The second pixel unit includes one second light emitting element emitting light of the first color, one second light emitting element emitting light of the second color, and two second light emitting elements emitting light of the third color; and the four second light emitting elements included in the second pixel unit are arranged in a shape of a diamond.

In some exemplary implementation modes, an area of a light emitting region of the first light emitting element is less than an area of a light emitting region of a second light emitting element that emits light of a same color.

In some exemplary implementation modes, a ratio of the area of the light emitting region of the first light emitting element to the area of the light emitting region of the second light emitting element emitting the light of the same color is 10% to 50%.

In some exemplary implementation modes, the first openings are provided with a cathode patterning layer, and the cathode patterning layer is configured to prevent generation of the first cathode.

In some exemplary implementation modes, a pixel definition layer is disposed within the first openings, and a hole injection layer, a hole transport layer, an electron transport layer, an electron injection layer, and a patterned cathode layer are disposed sequentially on a side of the pixel definition layer away from the base substrate.

In another aspect, an embodiment provides a display apparatus, which includes the aforementioned display substrate.

Other aspects of the present disclosure may be comprehended after drawings and detailed description are read and understood.

### Brief Description of Drawings

Accompanying drawings are used for providing further understanding of technical solutions of the present disclosure, constitute a part of the specification, and are used for explaining the technical solutions of the present disclosure together with the embodiments of the present disclosure, but do not constitute limitations on the technical solutions of the present disclosure. Shapes and dimensions of one or more components in the drawings do not reflect actual scales, and are only intended to schematically describe contents of the present disclosure.
FIG. 1 is a schematic diagram of a display substrate according to at least one embodiment of the present disclosure.
FIG. 2 is a schematic diagram of a planar structure of a second display region of a display substrate according to at least one embodiment of the present disclosure.
FIG. 3 is a partial cross-sectional view of a second display region of a display substrate according to at least one embodiment of the present disclosure.
FIG. 4 is a schematic diagram of a partial plane structure of a display substrate according to at least one embodiment of the present disclosure.
FIG. 5 is a partial cross-sectional view of a first display region of a display substrate according to at least one embodiment of the present disclosure.
FIG. 6 is a partial cross-sectional view of a first display region of a display substrate according to at least one embodiment of the present disclosure.
FIG. 7 is a schematic diagram of another partial plane structure of a display substrate according to at least one embodiment of the present disclosure.
FIG. 8 is a schematic diagram of another partial plane structure of a display substrate according to at least one embodiment of the present disclosure.
FIG. 9 is another partial plan view of a display substrate according to at least one embodiment of the present disclosure.
FIG. 10 is another partial plan view of a display substrate according to at least one embodiment of the present disclosure.
FIG. 11 is another partial plan view of a display substrate according to at least one embodiment of the present disclosure.
FIG. 12 is another partial plan view of a display substrate according to at least one embodiment of the present disclosure.
FIG. 13 is a schematic diagram of a structure of a first light emitting element according to at least one embodiment of the present disclosure.
FIG. 14 is a graph of a light transmittance of a connection layer of a first light emitting element according to at least one embodiment of the present disclosure.
FIG. 15 is another partial plan view of a display substrate according to at least one embodiment of the present disclosure.
FIG. 16 is a schematic diagram of comparison between lifetime of a light emitting element with a Tandem structure and lifetime of a light emitting element including only a single emitting layer.
FIG. 17 is another partial plan view of a display substrate according to at least one embodiment of the present disclosure.
FIG. 18 is a schematic diagram of a display apparatus according to at least one embodiment of the present disclosure.

### Detailed Description

The embodiments of the present disclosure will be described below with reference to the drawings in detail. Implementation modes may be implemented in multiple different forms. Those of ordinary skills in the art may easily understand such a fact that modes and contents may be transformed into other forms without departing from the purpose and scope of the present disclosure. Therefore, the present disclosure should not be explained as being limited to contents recorded in following implementation modes only. The embodiments and features in the embodiments of the present disclosure may be randomly combined with each other if there is no conflict.

In the drawings, a size of one or more constituent elements, a thickness of a layer, or a region is sometimes exaggerated for clarity. Therefore, one mode of the present disclosure is not necessarily limited to the size, and a shape and a size of one or more components in the drawings do not reflect an actual scale. In addition, the accompanying drawings schematically illustrate ideal examples, and a mode of the present disclosure is not limited to shapes, numerical values, or the like shown in the drawings.

Ordinal numerals "first", "second", "third", etc., in the specification are set not to constitute limitations in numbers but only to avoid confusion between constituent elements. In the present disclosure, "plurality" represents two or more than two.

In the specification, for convenience, expressions "central", "above", "below", "front", "back", "vertical", "horizontal", "top", "bottom", "inside", "outside", etc., indicating directional or positional relationships are used to illustrate positional relationships between the constituent elements with reference to the drawings, not to indicate or imply that a referred apparatus or element must have a specific orientation and be structured and operated with the specific orientation but only to easily and simply describe the specification, and thus should not be understood as limitations on the present disclosure. The positional relationships between the constituent elements are changed as appropriate according to a direction where the constituent elements are described. Therefore, appropriate replacements based on situations are allowed, which is not limited to the expressions in the specification.

In the specification, unless otherwise specified and defined, terms "mounting", "mutual connection", and "connection" should be understood in a broad sense. For example, it may be a fixed connection, a detachable connection, or an integral connection; it may be a mechanical connection or a connection; it may be a direct connection, an indirect connection through a middleware, or internal communication inside two elements. Those of ordinary skills in the art may understand meanings of the aforementioned terms in the present disclosure according to situations.

In the specification, an "electrical connection" includes a case that constituent elements are connected together through an element having some electrical function. The "element having some electrical function" is not particularly limited as long as electrical signals between the connected constituent elements may be transmitted. Examples of the "element having some electrical function" not only include an electrode and a wiring, but also include a switching element such as a transistor, a resistor, an inductor, a capacitor, another element with multiple functions, etc.

In the specification, a transistor refers to an element which at least includes three terminals, i.e., a gate, a drain, and a source. The transistor has a channel region between the drain (drain electrode terminal, drain region, or drain electrode) and the source (source electrode terminal, source region, or source electrode), and a current can flow through the drain, the channel region, and the source. In the specification, the channel region refers to a region through which a current mainly flows.

In the specification, a first electrode may be a drain and a second electrode may be a source, or, a first electrode may be a source and a second electrode may be a drain. In a case that transistors with opposite polarities are used, or in a case that a direction of a current is changed during operation of a circuit, or the like, functions of the "source" and the "drain" are sometimes interchangeable. Therefore, the "source" and the "drain" are interchangeable in the specification. In addition, the gate may also be referred to as a control electrode.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

A triangle, rectangle, trapezoid, pentagon, or hexagon, etc. in the specification is not strictly defined, and it may be an approximate triangle, rectangle, trapezoid, pentagon, or hexagon, etc. There may be some small deformations caused by tolerance, and there may be a chamfer, an arc edge, deformation, etc.

A "light transmittance" in the present disclosure refers to an ability of light to pass through a medium, and is a percentage of luminous flux passing through a transparent or translucent body to its incident luminous flux.

In the specification, "about" and "substantially" refer to that a boundary is not defined strictly and a case within a process and measurement error range is allowed. In the specification, "substantially the same" refers to a case where numerical values differ by less than 10%.

In some implementation modes, a light emitting element of an OLED display substrate may include an anode, a cathode, and an organic light emitting structure disposed between the anode and the cathode. The cathode may generally be made of a material such as Magnesium (Mg) or Argentum (Ag), the material of the cathode has good electrical conductivity but a relatively low transmittance. In a solution of a transparent display substrate, a cathode will affect a light transmittance of the display substrate adversely. In order to improve this situation, the cathode may be patterned. For example, methods of cathode patterning may include following three types: a photo-mask solution, a laser solution, and an Organic Thin-film Innovations Lumionics (OTI) solution. However, the photo-mask solution can only correspond to a display substrate with a resolution of less than 200 Pixels Per Inch (PPI), and it needs to be achieved through evaporation twice, which cannot meet a demand of display products with a resolution of more than 400 PPI, such as mobile phones. Although the laser solution may meet a demand of a high resolution, a device used in this solution is very expensive and has a long device investment time, so it is difficult to meet a customer's demand in a short time. In the OTI solution, a Cathode Patterning Material (CPM) is evaporated by using a Fine Metal Mask (FMM). Since the CPM does not stick to a cathode material, a cathode opening may be formed at the CPM during cathode evaporation, thus achieving cathode patterning. However, the OTI solution is limited to a design ability of the FMM, and can only support display products with a resolution less than 400 PPI, which is difficult to meet demands of customers for a high resolution.

A display substrate is provided in an embodiment, which includes a base substrate, a plurality of first pixel units, and a plurality of second pixel units. The base substrate includes a first display region and a second display region located on least one side of the first display region. The plurality of first pixel units are located in the first display region. A first pixel unit includes a plurality of first light emitting elements. A first pixel unit includes a first anode, a first organic light emitting structure, and a first cathode disposed sequentially along a direction away from the base substrate. The first cathode has a plurality of first openings, and orthographic projections of the first openings on the base substrate are not overlapped with orthographic projections of light emitting regions of the first light emitting elements on the base substrate. The plurality of second pixel units are located in the second display region. A second pixel unit includes a plurality of second light emitting elements. A second pixel unit includes a second anode, a second organic light emitting structure, and a second cathode disposed sequentially along the direction away from the base substrate. A sum of areas of the light emitting regions of the first light emitting elements of the first display region is less than a sum of areas of light emitting regions of the second light emitting elements of the second display region.

In some examples, an area of a light emitting region of a single first light emitting element of the first display region may be less than an area of a light emitting region of a second light emitting element that emits light of a same color. For example, a ratio of an area of a light emitting region of a first light emitting element to an area of a light emitting region of a second light emitting element that emits light of a same color may be 10% to 50%. In the example, when a quantity of the first light emitting elements of the first display region is less than or equal to a quantity of the second light emitting elements of the second display region, a sum of areas of light emitting regions of the first light emitting elements of the first display region may be less than a sum of areas of light emitting regions of the second light emitting elements of the second display region. However, the embodiment is not limited thereto. In other examples, an area of a light emitting region of a single first light emitting element of the first display region may be greater than or equal to an area of a light emitting region of a single second light emitting element of the second display region, and the quantity of the first light emitting elements of the first display region is less than the quantity of the second light emitting elements of the second display region, so that a sum of areas of light emitting regions of the first light emitting elements of the first display region is less than a sum of areas of light emitting regions of the second light emitting elements of the second display region. In other examples, areas of light emitting regions of a part of the first light emitting elements of the first display region may be less than areas of light emitting regions of the second light emitting elements of the second display region, areas of light emitting regions of another part of the first light emitting elements may be greater than the areas of the light emitting regions of the second light emitting elements, and the quantity of the first light emitting elements of the first display region is less than or equal to the quantity of the second light emitting elements of the second display region, so that the sum of areas of the light emitting regions of the first light emitting elements of the first display region is less than the sum of areas of light emitting regions of the second light emitting elements of the second display region.

For the display substrate according to the embodiment, it is helpful to increase a dimension of a first opening of the first cathode in the first display region by configuring that the sum of the areas of the light emitting regions of the first light emitting elements of the first display region is less than the sum of the areas of the light emitting regions of the second light emitting elements of the second display region, thereby improving a light transmittance of the first display region while ensuring a display effect of the first display region.

In some examples, the second cathode and the first cathode may be of an integral structure.

In some exemplary implementation modes, a spacing between at least one first light emitting element and an adjacent first light emitting element in at least one first pixel unit among the plurality of first pixel units is less than a spacing between the first light emitting element and an adjacent first light emitting element in at least one adjacent first pixel unit. In the example, a spacing between first light emitting elements is changed by disposing first light emitting elements in a first pixel unit in the first display region centrally, so that a spacing between at least one first light emitting element and an adjacent first light emitting element in at least one first pixel unit is less than a spacing between the first light emitting element and an adjacent first light emitting element in at least one adjacent first pixel unit, thereby increasing a dimension of a first opening of the first cathode to meet a design capability of the FMM, thereby improving the light transmittance of the first display region while ensuring the display effect of the first display region.

In the embodiment of the present disclosure, a spacing between A and B refers to a distance between a center position of A and a center position of B.

In some exemplary implementation modes, at least one first pixel unit may share at least one first light emitting element with an adjacent first pixel unit. In some examples, an arrangement mode of the plurality of first light emitting elements of the first display region may be adjusted, so that at least one first pixel unit shares at least one first light emitting element with an adjacent first pixel unit, thereby the dimension of the first opening of the first cathode may be increased to satisfy the design capability of the FMM.

In some exemplary implementation modes, at least one first pixel unit may include only a plurality of first light emitting elements emitting light of different colors. In some examples, an arrangement mode of the plurality of first light emitting elements of the first display region is adjusted, so that at least one first pixel unit includes only a plurality of first light emitting elements emitting light of different colors (e.g., including one first light emitting element emitting light of a first color, one first light emitting element emitting light of a second color, and one first light emitting element emitting light of a third color), thereby the dimension of the first opening of the first cathode is increased to satisfy the design capability of the FMM. In some examples, the light of the first color may be red light, the light of the second color may be blue light, and the light of the third color may be green light. However, the embodiment is not limited thereto.

In some exemplary implementation modes, a first organic light emitting structure of at least one first light emitting element includes at least a plurality of emitting layers stacked, wherein a connection unit is disposed between adjacent emitting layers. In some examples, a post spacer may be disposed around the first light emitting element, and the connection unit may be disconnected at a position of the post spacer.

In some examples, the first light emitting element may be a light emitting element with a Tandem structure. The light emitting element with the Tandem structure may be stacked in series with a plurality of emitting layers to form an efficient light emitting device. Designing the first light emitting element to have a Tandem structure may reduce an area of a first anode of the first light emitting element, thereby increasing the dimension of the first opening of the first cathode on a basis of ensuring the display effect and service life.

In some examples, the dimension of the first opening of the first cathode may be increased by adjusting at least one of a position, an arrangement mode, and an organic light emitting structure of a first light emitting element of the first display region, so that the light transmittance of the first display region may be improved on a basis of ensuring the display effect of the first display region.

In some exemplary implementation modes, the first opening may be located between adjacent first pixel units. However, the embodiment is not limited thereto. For example, the first opening may be located between adjacent first light emitting elements in a first pixel unit.

In some exemplary implementation modes, a pixel center of at least one first pixel unit may be different from a pixel center of a second pixel unit. In some examples, a position of at least one first light emitting element in a first pixel unit is changed, so that a pixel center of the first pixel unit may be different from a pixel center of a second pixel unit. Or, an arrangement mode of a plurality of first light emitting elements in the first pixel unit is different from an arrangement mode of a plurality of second light emitting elements in the second pixel unit, so that the pixel center of the first pixel unit may be different from the pixel center of the second pixel unit.

In some exemplary implementation modes, a spacing between at least one first light emitting element and an adjacent first light emitting element in at least one first pixel unit may be less than a spacing between at least one second light emitting element and an adjacent second light emitting element in a second pixel unit; the first light emitting element and the second light emitting element emit light of a same color. In the example, a dimension of a first opening of a first cathode is widened by adjusting a position of at least one first light emitting element in the first pixel unit such that a plurality of first light emitting elements in the first pixel unit may be centrally disposed.

In some exemplary implementation modes, a quantity of first light emitting elements included in a first pixel unit may be different from a quantity of second light emitting elements included in a second pixel unit. For example, the quantity of the first light emitting elements included in the first pixel unit may be less than the quantity of the second light emitting elements included in the second pixel unit. In some examples, the first pixel unit may include one first light emitting element that emits light of a first color, one first light emitting element that emits light of a second color, and one first light emitting element that emits light of a third color, and the second pixel unit may include one second light emitting element that emits light of the first color, one second light emitting element that emits light of the second color, and two second light emitting elements that emit light of the third color; wherein the four second light emitting elements included in the second pixel unit may be arranged in a shape of a diamond. In the example, a first opening of a first cathode may be disposed at a position where a quantity of light emitting elements in the first pixel unit is less than that in the second pixel unit, thereby increasing a dimension of the first opening on a basis of ensuring the display effect of the first display region.

In some exemplary implementation modes, the dimension of the first opening of the first cathode may be greater than or equal to 20 microns, for example, may be about 23 microns or 26 microns. A minimum distance between adjacent edges of two adjacent first openings may be greater than or equal to 10 microns, for example, may be about 10 microns or 15 microns. When the first opening has a shape of a square, the dimension of the first opening may be a side length of the first opening. When the first opening is circular, the dimension of the first opening may be a radius of the first opening. However, the embodiment is not limited thereto.

Solutions of the embodiments will be described below through some examples.

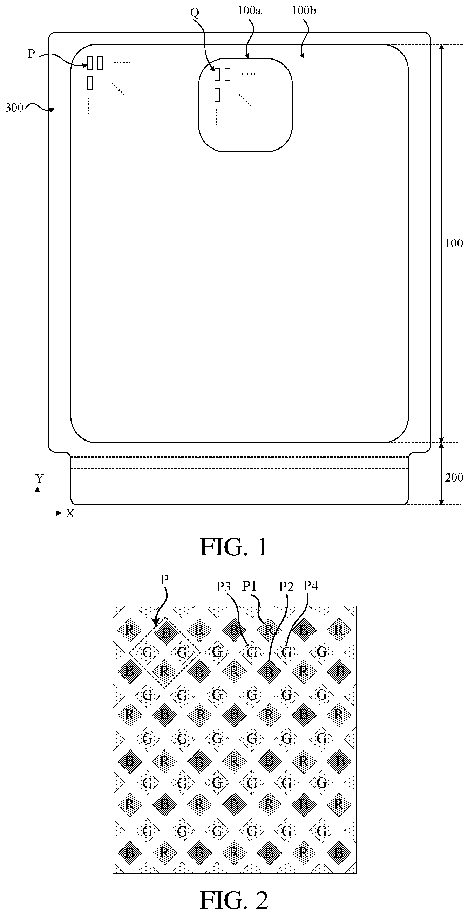

FIG. 1 is a schematic diagram of a display substrate according to at least one embodiment of the present disclosure. In some examples, as shown in FIG. 1, the display substrate may include a display region 100, a first bezel region 200 located on a side of the display region 100, and a second bezel region 300 located on another side of the display region 100. The first bezel region 200 and the second bezel region 300 may communicate and surround the display region 100. In some examples, the display region 100 may be a flat region. In some examples, the display substrate may be a flexible substrate. Accordingly, the display substrate may be deformable, for example, may be crimped, bent, folded, or curled.

In some examples, as shown in FIG. 1, the display region 100 may include a first display region 100a, and a second display region 100b located on at least one side of the first display region 100a. The first display region 100a may also be referred to as an Under Display Camera (UDC) region. The second display region 100b is a non-transparent display region and may also be referred to as a normal display region. For example, an orthographic projection of a photosensitive sensor (e.g., a camera, an infrared sensor, and other hardware) on the display substrate may be located within the first display region 100a of the display substrate. In some examples, as shown in FIG. 1, the first display region 100a may be circular and a dimension of the orthographic projection of the photosensitive sensor on the display substrate may be less than or equal to a dimension of the first display region 100a. However, the embodiment is not limited thereto. In other examples, the first display region may be rectangular, and the dimension of the orthographic projection of the photosensitive sensor on the display substrate may be less than or equal to a dimension of an inscribed circle of the first display region.

In some examples, as shown in FIG. 1, the first display region 100a may be located at a middle position of a top of the display region 100. The second display region 100b may surround the first display region 100a. However, the embodiment is not limited thereto. For example, the first display region 100a may be located at another position, such as an upper left corner or an upper right corner of the display region 100.

In some examples, as shown in FIG. 1, the display region 100 may be in a shape of a rectangle, e.g., a rounded rectangle. The first display region 100a may be circular or elliptical. However, the embodiment is not limited thereto. For example, the first display region may be rectangular, pentagonal, hexagonal, or in another shape.

In some examples, as shown in FIG. 1, the first display region 100a may include at least a plurality of first pixel units Q, wherein at least one first pixel unit Q may include a plurality of first region sub-pixels. The second display region 100b may include at least a plurality of second pixel units P, wherein at least one second pixel unit P may include a plurality of second region sub-pixels. In some examples, a shape of a sub-pixel may be a rectangle, a rhombus, a pentagon, or a hexagon. When one pixel unit includes three sub-pixels, the three sub-pixels may be arranged side by side horizontally, side by side vertically, or in a manner like a Chinese character " 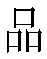 "; when one pixel unit includes four sub-pixels, the four sub-pixels may be arranged side by side horizontally, side by side vertically, or in a shape of a square. However, the embodiment is not limited thereto.

In some examples, at least one sub-pixel may include a pixel circuit and a light emitting element. The pixel circuit may be configured to drive a connected light emitting element. For example, the pixel circuit is configured to provide a drive current to drive the light emitting element to emit light. The pixel circuit may include a plurality of transistors and at least one capacitor. For example, the pixel circuit may be of a 3T1C, 4T1C, 5T1C, 5T2C, 6T1C, 7T1C, or 8T1C structure. In the above circuit structure, T refers to a thin film transistor, C refers to a capacitor, a number before T represents a quantity of thin film transistors in the circuit, and a number before C represents a quantity of capacitors in the circuit. In some examples, the plurality of transistors in the pixel circuit may be P-type transistors or N-type transistors. Use of a same type of transistors in the pixel circuit may simplify a process flow, reduce a process difficulty of the display substrate, and improve a yield of products. In some other examples, the plurality of transistors in the pixel circuit may include a P-type transistor and an N-type transistor.

In some examples, low temperature poly silicon thin film transistors, or oxide thin film transistors, or a low temperature poly silicon thin film transistor and an oxide thin film transistor may be used for the plurality of transistors in the pixel circuit. An active layer of a low temperature poly silicon thin film transistor is made of Low Temperature Poly Silicon (LTPS), and an active layer of an oxide thin film transistor is made of an oxide semiconductor (Oxide). The low temperature poly silicon thin film transistor has advantages such as a high migration rate and fast charging, and the oxide thin film transistor has advantages such as a low leakage current. The low temperature poly silicon thin film transistor and the oxide thin film transistor are integrated on one display panel, that is, an LTPS + Oxide (LTPO for short) display panel, advantages of both the low temperature poly silicon thin film transistor and the oxide thin film transistor may be utilized, low-frequency drive may be achieved, power consumption may be reduced, and display quality may be improved.

In some example, the light emitting element may be an Organic Light Emitting Diode (OLED), and the light emitting element emits red light, green light, blue light, or white light, etc. when driven by a pixel circuit corresponding to the light emitting element. A color of light emitted by the light emitting element may be determined as required. The light emitting element may include an anode, a cathode, and an organic light emitting structure located between the anode and the cathode. The anode of the light emitting element may be electrically connected with the corresponding pixel circuit. However, the embodiment is not limited thereto.

In some examples, a first region sub-pixel may include a first light emitting element and a first pixel circuit electrically connected with the first light emitting element. For example, the first pixel circuit may be disposed in the second display region 100b and electrically connected with the first light emitting element located in the first display region 100a through a transparent conductive line. Or, both the first pixel circuit and the first light emitting element may be disposed in the first display region 100a and the first pixel circuit may be located below the first light emitting element to reduce an influence on a light transmittance of the first display region 100a. A second region sub-pixel may include a second light emitting element and a second pixel circuit electrically connected with the second light emitting element. The second light emitting element and the second pixel circuit may be located in the second display region 100b. For example, within the second display region 100b, space for arranging first pixel circuits may be obtained by compressing the second pixel circuit, or the first pixel circuits may be arranged within the second bezel region 300. However, the embodiment is not limited thereto.

In some examples, as shown in FIG. 1, the first bezel region 200 may include a fanout region, a bending region, a drive chip region, and a bonding pin region that are sequentially disposed along a direction away from the display region 100. The fanout region is connected to the display region 100 and at least includes data fanout lines. A plurality of data fanout lines are configured to be connected with a data signal line of the display region 100 in a fanout routing manner. The bending region is connected to the fanout region and may include a composite insulation layer provided with a groove, and is configured to enable the drive chip region and the bonding pin region to be bent to a back of the display region 100. The driver chip region may be provided with an Integrated Circuit (IC) that may be configured to be connected with the plurality of data fanout lines. The bonding pin region may include a bonding pad that may be configured to be bonded and connected with an external Flexible Printed Circuit (FPC).

In some examples, as shown in FIG. 1, the second bezel region 300 may include a circuit region, a power supply line region, a crack dam region, and a cutting region disposed sequentially along the direction away from the display region 100. The circuit region is connected to the display region 100 and may at least include a gate drive circuit, and the gate drive circuit is connected with a first scan line, a second scan line, and a light emitting control line, which are connected with a pixel drive circuit in the display region 100. The power supply line region is connected to the circuit region and may at least include a bezel power supply lead, and the bezel power supply lead extends along a direction parallel to an edge of the display region and is connected with a cathode in the display region 100. The crack dam region is connected to the power supply line region and may at least include a plurality of cracks disposed on the composite insulation layer. The cutting region is connected to the crack dam region, and may include, at least, a cutting groove disposed on the composite insulation layer, wherein the cutting groove is configured for respectively cutting along the cutting groove by a cutting device after preparation of all film layers of the display substrate is completed.

In some examples, the fanout region in the first bezel region 200 and the power supply line region in the second bezel region 300 may be provided with a first dam spacer and a second dam spacer, wherein the first dam spacer and the second dam spacer may extend along the direction parallel to the edge of the display region, thus forming an annular structure surrounding the display region 100. The edge of the display region is an edge of the display region 100 on a side close to the first bezel region 200 or the second bezel region 300.

FIG. 2 is a schematic diagram of a planar structure of a second display region of a display substrate according to at least one embodiment of the present disclosure. In some examples, as shown in FIG. 2, the second display region of the display substrate may include a plurality of second pixel units P arranged in a matrix manner. At least one second pixel unit P may include a second light emitting element P1 emitting light of a first color, a second light emitting element P2 emitting light of a second color, and a second light emitting element P3 and a second light emitting element P4 emitting light of a third color. For example, the light of the first color may be red light (R), the light of the second color may be blue light (B), and the light of the third color may be green light (G). However, the embodiment is not limited thereto.

In some examples, a second light emitting element may have a shape of a rectangle, a rhombus, a pentagon, or a hexagon. Four light emitting elements of a second pixel unit P may be arranged in a manner of a diamond to form an RGBG pixel arrangement. In another exemplary embodiment, the four light emitting elements may be arranged side by side horizontally, side by side vertically, or in a manner to form a square, etc., which is not limited here in the present disclosure.

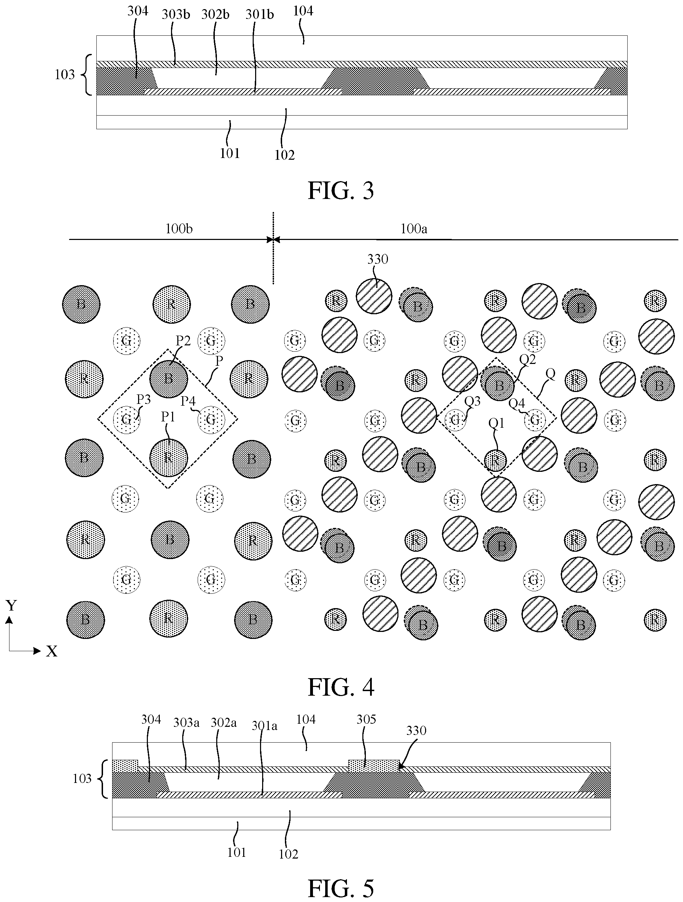

FIG. 3 is a partial cross-sectional view of a second display region of a display substrate according to at least one embodiment of the present disclosure. FIG. 3 illustrates a structure of two second region sub-pixels within the second display region of the display region 100. In some examples, as shown in FIG. 3, in a direction perpendicular to the display substrate, the second display region may include a base substrate 101, and a circuit structure layer 102, a light emitting structure layer 103, and an encapsulation structure layer 104 which are disposed on the base substrate 101, sequentially. In some possible implementation modes, the display substrate may include another film layer, such as a touch structure layer, which is not limited here in the present disclosure.

In some examples, as shown in FIG. 3, the base substrate 101 may be a flexible base substrate or may be a rigid base substrate. The circuit structure layer 102 of each second region sub-pixel may include a second pixel circuit composed of a plurality of transistors and a storage capacitor. The light emitting structure layer 103 of each second region sub-pixel may include, at least, a second anode 301b, a pixel definition layer 304, a second organic light emitting structure 302b, and a second cathode 303b. The second anode 301b is electrically connected with the second pixel circuit, the second organic light emitting structure 302b is connected with the second anode 301b, the second cathode 303b is connected with the second organic light emitting structure 302b, and the second organic light emitting structure 302b is driven by the second anode 301b and the second cathode 303b to emit light of a corresponding color. Second cathodes 303b of a plurality of second light emitting elements of the second display region may be of an integral structure. The second cathodes 303b of the second display region may be of a whole surface structure.

In some examples, the second organic light emitting structure 303b may include an Emitting Layer (EML), and any one or more of following layers: a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In some examples, one or more layers of hole injection layers, hole transport layers, electron block layers, hole block layers, electron transport layers, and electron injection layers of all second region sub-pixels may be respectively connected together to be a common layer. Emitting layers of adjacent second region sub-pixels may be overlapped slightly, or may be mutually isolated.

In some examples, as shown in FIG. 3, the encapsulation structure layer 104 may include a first encapsulation layer, a second encapsulation layer, and a third encapsulation layer that are stacked, wherein the first encapsulation layer and the third encapsulation layer may be made of an inorganic material, the second encapsulation layer may be made of an organic material, and the second encapsulation layer may be disposed between the first encapsulation layer and the third encapsulation layer to form a laminated structure of an inorganic material/an organic material/an inorganic material, which may ensure that external water vapor cannot enter the light emitting structure layer.

FIG. 4 is a schematic diagram of a partial plane structure of a display substrate according to at least one embodiment of the present disclosure. In some examples, as shown in FIG. 4, a first display region 100a of the display substrate may include a plurality of first pixel units Q arranged in a matrix manner. At least one of the first pixel units Q may include a first light emitting element Q1 that emits light of a first color, a first light emitting element Q2 that emits light of a second color, and a first light emitting element Q3 and a first light emitting element Q4 that emit light of a third color. For example, the light of the first color may be red light (R), the light of the second color may be blue light (B), and the light of the third color may be green light (G).

In some examples, as shown in FIG. 4, a first light emitting element may have a shape of a circle or an ellipse. Four first light emitting elements of a first pixel unit Q may be arranged in a manner of a diamond to form an RGBG pixel arrangement. For example, the first light emitting element Q1 and the first light emitting element Q2 may be arranged at intervals in a same row along a first direction X, and arranged at intervals in a same column along a second direction Y. The first light emitting element Q3 and the first light emitting element Q4 may be arranged at intervals in a same row along the first direction X and arranged at intervals in a same column along the second direction Y. A row where the first light emitting element Q1 and the first light emitting element Q2 are located and a row where the first light emitting element Q3 and the first light emitting element Q4 are located are arranged at intervals, and a column where the first light emitting element Q1 and the first light emitting element Q2 are located and a column where the first light emitting element Q3 and the first light emitting element Q4 are located are arranged at intervals. The first direction X intersects with the second direction Y. For example, the first direction X may be perpendicular to the second direction Y. An arrangement mode of the four first light emitting elements of the first pixel unit Q may be substantially the same as an arrangement mode of the four second light emitting elements of the second pixel unit P.

In some examples, as shown in FIG. 4, a second display region 100b of the display substrate may include a plurality of second pixel units P arranged in a matrix manner. At least one second pixel unit P may include a second light emitting element P1 emitting light of a first color, a second light emitting element P2 emitting light of a second color, and a second light emitting element P3 and a second light emitting element P4 emitting light of a third color. A second light emitting element may have a shape of a circle or an ellipse, or may be diamond-shaped as shown in FIG. 2. An arrangement mode of four second light emitting elements of a second pixel unit P is substantially the same as an arrangement mode of four first light emitting elements of a first pixel circuit Q. For a second light emitting element and a first light emitting element emitting light of a same color, an area of a light emitting region of the first light emitting element may be less than an area of a light emitting region of the second light emitting element.

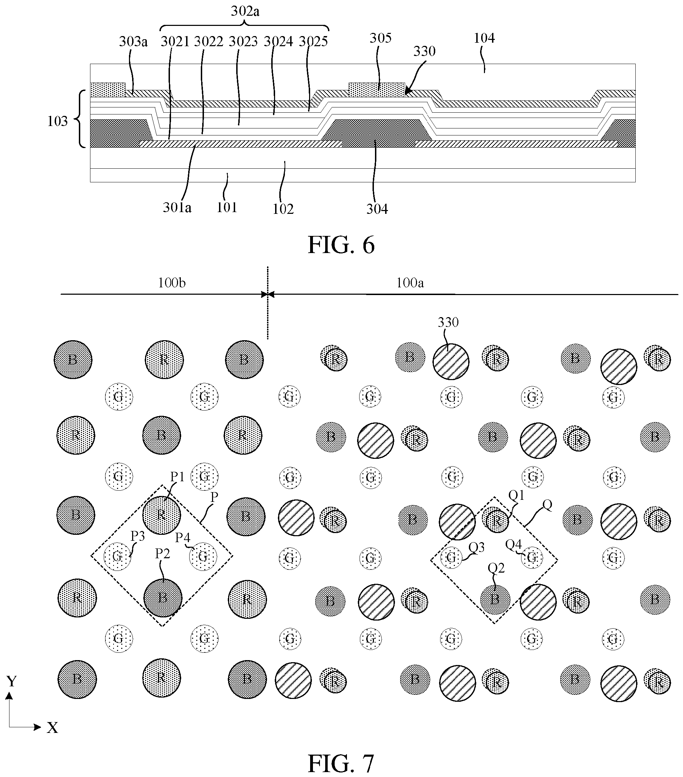

FIGs. 5 and 6 are schematic partial cross-sectional views of a first display region of a display substrate according to at least one embodiment of the present disclosure. FIGs. 5 and 6 illustrate structures of two first region sub-pixels in a second display region of a display region 100. In some examples, as shown in FIGs. 5 and 6, in a direction perpendicular to the display substrate, the first display region may include a base substrate 101, and a circuit structure layer 102, a light emitting structure layer 103, and an encapsulation structure layer 104 which are disposed on the base substrate 101, sequentially. In some possible implementation modes, the display substrate may include another film layer, such as a touch structure layer, which is not limited here in the present disclosure.

In some examples, as shown in FIGs. 5 and 6, the circuit structure layer 102 of each first region sub-pixel may include a first pixel circuit composed of a plurality of transistors and a storage capacitor. Or, a first pixel circuit may be disposed in the second display region, and the circuit structure layer of the first display region may include a composite insulation layer. The light emitting structure layer 103 of each first region sub-pixel may include at least a first anode 301a, a pixel definition layer 304, a first organic light emitting structure 302a, and a first cathode 303a. The first anode 301a is electrically connected with the first pixel circuit, the first organic light emitting structure 302a is connected with the first anode 301a, the first cathode 303a is connected with the first organic light emitting structure 302a, and the first organic light emitting structure 302a is driven by the first anode 301a and the first cathode 303a to emit light of a corresponding color. First cathodes 303a of a plurality of first light emitting elements of the first display region may be of an integral structure. A first cathode 303a of the first display region and a second cathode of the second display region may be of an integral structure. The first cathode 303a may have a plurality of first openings 330 within which a cathode patterning layer 305 may be disposed. The cathode patterning layer 305 may be filled within the first openings 330. Orthographic projections of the first openings 330 on the base substrate are not overlapped with an orthographic projection of a light emitting region of a first light emitting element on the base substrate. An orthographic projection of the cathode patterning layer 305 on the base substrate is not overlapped with the orthographic projection of the light emitting region of the first light emitting element on the base substrate.

In some examples, as shown in FIG. 6, the first organic light emitting structure 302a may include a hole injection layer 3021, a hole transport layer 3022, an emitting layer 3023, an electron transport layer 3024, and an electron injection layer 3025 which are stacked sequentially. Among them, the hole injection layer 3021, the hole transport layer 3022, the electron transport layer 3024, and the electron injection layer 3025 may be disposed on a whole surface. For example, these film layers may be common layers of a plurality of first light emitting elements. The pixel definition layer 304 is disposed in the first openings 330, and the hole injection layer 3021, the hole transport layer 3022, the electron transport layer 3024, on a side of the pixel definition layer 304 away from the base substrate 101, there are the electron injection layer 3025, and the cathode patterning layer 305 sequentially.

In some examples, as shown in FIG. 4, dimensions of the plurality of first openings 330 of the first cathode 303a may be substantially the same. Shapes of the plurality of first openings 330 may be substantially the same. For example, the orthographic projections of the first openings 330 on the base substrate may be circular or elliptical. However, the embodiment is not limited thereto.

In an embodiment of the present disclosure, a light emitting region of a light emitting element refers to an overlapping region of an anode, an organic light emitting structure, and a cathode, that is, a connection region between an anode exposed by a pixel opening of the pixel definition layer, and an organic light emitting structure and a cathode.

In some examples, in a preparation process of the display substrate, after the pixel definition layer 304 is prepared, a cathode patterning material may be evaporated and patterned through a patterning process, for example, a part of the cathode patterning material on the pixel definition layer 304 may be retained to form the cathode patterning layer 305. Subsequently, the organic light emitting structure and the cathode are prepared in sequence. Since the cathode patterning material does not stick to a cathode material, the cathode patterning layer 305 will not be covered by the cathode material in an evaporation process of the cathode material, and formation of the first cathode 303a may be prevented, thereby naturally forming the first openings 330 of the first cathode 303a.

The "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto.

In some examples, an area of a light emitting region of a first light emitting element may be less than an area of a light emitting region of a second light emitting element that emits light of a same color. An area of a first anode of the first light emitting element may be less than an area of a second anode of the second light emitting element emitting light of the same color. For example, the area of the light emitting region of the first light emitting element may be 45% to 50%, e.g., may be about 50%, of the area of the light emitting region of the second light emitting element that emits light of the same color. By reducing the area of the light emitting region of the first light emitting element of the first display region, a light transmittance of the first display region may be improved.

In some examples, compared with four second light emitting elements within a second pixel unit P, a position of at least one first light emitting element within a first pixel unit Q is changed. In the example, taking a case that a position of a first light emitting element Q2 is changed as an example, a first light emitting element Q2 shown by a solid line in FIG. 4 is a first light emitting element Q2 moved to a final position, and a first light emitting element Q2 shown by a dashed line is a first light emitting element Q2 before moving. Before the first light emitting element Q2 is moved, a positional relationship of four first light emitting elements within the first pixel unit Q may be substantially the same as a positional relationship of the four second light emitting elements within the second pixel unit P, and a pixel center of the first pixel unit Q may be the same as a pixel center of the second pixel unit P. In the example, the first light emitting element Q2 may be moved a distance along a third direction. The third direction may be an extension direction of a connection line of center points of the first light emitting element Q2 and the first light emitting element Q4. After the first light emitting element Q2 is moved along the third direction, a spacing between the first light emitting element Q2 and the first light emitting element Q4 within the first pixel unit Q may be reduced, and a spacing between the first light emitting element Q2 and the first light emitting element Q1 may be reduced. The spacing between the first light emitting element Q2 and the first light emitting element Q4 within the first pixel unit Q may be less than a spacing between the second light emitting element P2 and the second light emitting element P4 within the second pixel unit P, and the spacing between the first light emitting element Q2 and the first light emitting element Q1 within the first pixel unit Q may be less than a spacing between the second light emitting element P2 and the second light emitting element P1 within the second pixel unit P. The spacing between the first light emitting element Q2 and the first light emitting element Q1 within the first pixel unit Q may be less than a spacing between the first light emitting element Q2 of the first pixel unit Q and a first light emitting element Q1 within a left adjacent first pixel unit Q, and is also less than a spacing between the first light emitting element Q2 of the first pixel unit Q and a first light emitting element Q1 within an upper adjacent first pixel unit Q.

In some examples, as shown in FIG. 4, a first opening 330 of the first cathode may be located between adjacent first pixel units Q along the first direction X or the second direction Y. For example, a first opening 330 of the first cathode may be located between a first light emitting element Q1 of a first pixel unit Q and a second light emitting element Q2 of an adjacent first pixel unit Q along the second direction Y, or may be located between a first light emitting element Q3 of a first pixel unit and a first light emitting element Q4 of an adjacent first pixel unit Q along the first direction X. A plurality of first openings 330 may be arranged sequentially adjacent along a fourth direction, and the fourth direction may intersect with both the first direction X and the second direction Y. For example, the fourth direction may be parallel to a centerline direction of an included angle between the first direction X and the second direction Y. For another example, the fourth direction may be perpendicular to the third direction. However, the embodiment is not limited thereto.

In the example, by moving positions of a plurality of first light emitting elements Q2 emitting the light of the second color of the first display region to achieve position concentration of four first light emitting elements within the first pixel unit Q, space between adjacent first pixel units may be increased, thus dimensions of the first openings may be increased. For example, taking the display substrate with 458 PPI of the example as an example, CD/Rib of an FMM used for patterning the first cathode of the first display region may be about 23 microns / 15 microns, which may meet a design requirement of the FMM. Among them, CD represents a dimension of an opening of the FMM, and Rib represents a distance between edges of adjacent openings. When the opening of the FMM has a shape of a square, CD may be a side length of the square. When the opening of the FMM is round, CD may be a radius.

In the example, after the positions of the plurality of first light emitting elements Q2 of the first display region are moved, a pixel center of the first pixel unit Q is changed. Therefore, pixel centers of the first pixel unit Q and the second pixel unit P are inconsistent, and there is an offset.

FIG. 7 is a schematic diagram of another partial plane structure of a display substrate according to at least one embodiment of the present disclosure. In some examples, taking a case that a position of the first light emitting element Q1 is changed as an example, the first light emitting element Q1 shown by a solid line in FIG. 7 is a first light emitting element Q1 moved to a final position, and the first light emitting element Q1 shown by a dashed line is a first light emitting element Q1 before moving. Before the first light emitting element Q1 is moved, a positional relationship of the four first light emitting elements within the first pixel unit Q may be substantially the same as a positional relationship of the four second light emitting elements within the second pixel unit P, and a pixel center of the first pixel unit Q may be the same as a pixel center of the second pixel unit P. In the example, the first light emitting element Q1 may be moved along an extension direction of a connection line of center points of the first light emitting element Q1 and the first light emitting element Q4. After the first light emitting element Q1 is moved along the above-mentioned direction, a spacing between the first light emitting element Q1 and the first light emitting element Q4 within the first pixel unit Q may be reduced, and a spacing between the first light emitting element Q1 and the first light emitting element Q2 may be reduced. The spacing between the first light emitting element Q1 and the first light emitting element Q4 within the first pixel unit Q may be less than a spacing between the second light emitting element P2 and the second light emitting element P4 within the second pixel unit P, and the spacing between the first light emitting element Q2 and the first light emitting element Q1 within the first pixel unit Q may be less than a spacing between the second light emitting element P2 and the second light emitting element P1 within the second pixel unit P. The spacing between the first light emitting element Q1 and the first light emitting element Q2 within the first pixel unit Q may be less than a spacing between the first light emitting element Q1 of the first pixel unit Q and a first light emitting element Q2 within a right adjacent first pixel unit Q, and is also less than a spacing between the first light emitting element Q1 of the first pixel unit Q and a first light emitting element Q2 within an upper adjacent first pixel unit Q.

In some examples, as shown in FIG. 7, a first opening 330 of the first cathode may be located between adjacent first pixel units Q along a first direction X or a second direction Y. For example, a first opening 330 of the first cathode may be located between a first light emitting element Q1 of a first pixel unit and a first light emitting element Q2 of an adjacent first pixel unit Q along the first direction X. However, the embodiment is not limited thereto.

With regard to rest of a structure of the display substrate of the embodiment, reference may be made to description of the above-mentioned embodiments, and will not be repeated here.

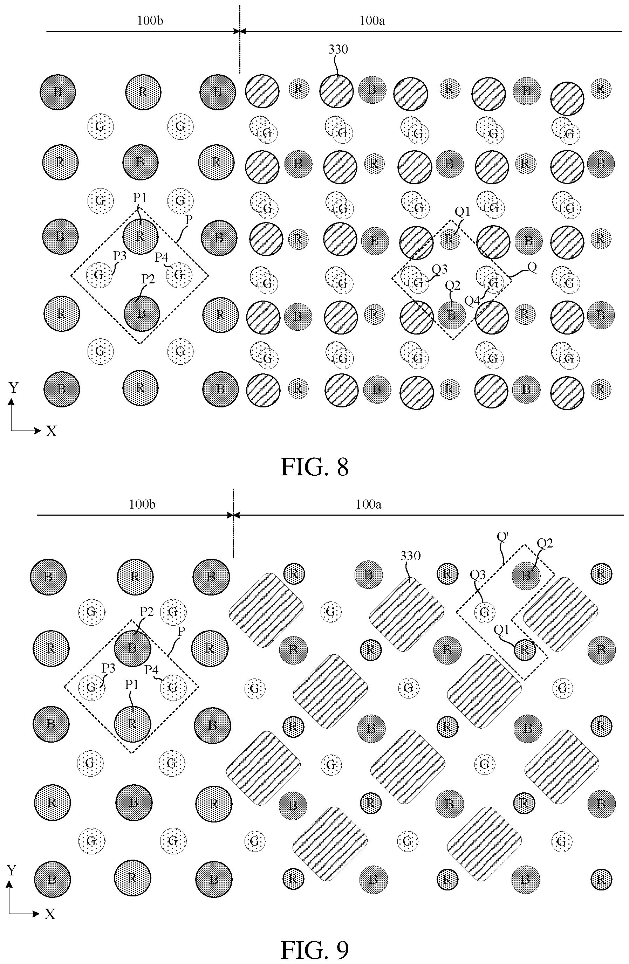

FIG. 8 is a schematic diagram of another partial plane structure of a display substrate according to at least one embodiment of the present disclosure. In some examples, taking a case that positions of a first light emitting element Q3 and a first light emitting element Q4 are changed as an example, the first light emitting element Q3 and the first light emitting element Q4 shown by solid lines in FIG. 8 are a first light emitting element Q3 and a first light emitting element Q4 moved to final positions, and the first light emitting element Q3 and the first light emitting element Q4 shown by dashed lines are a first light emitting element Q3 and a first light emitting element Q4 before moving. Before the first light emitting element Q3 and the first light emitting element Q4 are moved, a positional relationship of four first light emitting elements within the first pixel unit Q may be substantially the same as a positional relationship of four second light emitting elements within the second pixel unit P, and a pixel center of the first pixel unit Q may be the same as a pixel center of the second pixel unit P. In the example, the first light emitting element Q3 may be moved along an extension direction of a connection line of center points of the first light emitting element Q3 and the first light emitting element Q2, and the first light emitting element Q4 may be moved along an extension direction of a connection line of center points of the first light emitting element Q4 and the first light emitting element Q1. Moving directions of the first light emitting element Q3 and the first light emitting element Q4 may be parallel to each other. After the first light emitting element Q3 and the first light emitting element Q4 are moved, a spacing between the first light emitting element Q2 and the first light emitting element Q3 within the first pixel unit Q may be reduced, and a spacing between the first light emitting element Q4 and a first light emitting element Q1 of an adjacent first pixel unit Q may be reduced.

In some examples, as shown in FIG. 8, a first opening 330 of the first cathode may be located between adjacent first pixel units Q along a first direction X or a second direction Y. For example, the first opening 330 of the first cathode may be located between a first light emitting element Q1 of a first pixel unit and a second light emitting element Q2 of an adjacent first pixel unit Q along the first direction X, or may be located between a first light emitting element Q3 of a first pixel unit and a first light emitting element Q3 of an adjacent first pixel unit Q along the second direction Y. However, the embodiment is not limited thereto.

With regard to rest of a structure of the display substrate of the embodiment, reference may be made to description of the above-mentioned embodiments, and will not be repeated here.

In other examples, a position of a first light emitting element emitting green light may be adjusted, or positions of first light emitting elements emitting red light and blue light may be adjusted, or positions of first light emitting element emitting blue light and green light may be adjusted, or positions of first light emitting elements emitting red light, blue light, and green light may be adjusted. However, the embodiment is not limited thereto.

In other examples, when the positions of the first light emitting elements emitting red light, green light, and blue light are adjusted with reference to a pixel center of a first pixel unit, the pixel center of the first pixel unit may be kept unchanged, at this time, the pixel center of the first pixel unit may not be shifted before and after the positions of the first light emitting elements are moved. A non-light emitting region between adjacent first pixel units may be widened to facilitate increasing the dimension of the first opening of the first cathode.

In some examples, each first pixel unit of the first display region may include four first light emitting elements. For example, the first display region may include N first light emitting elements emitting light of a first color, N first light emitting elements emitting light of a second color, and 2N first light emitting elements emitting light of a third color. For the 2N first light emitting elements emitting the light of the third color within the first display region, n first light emitting elements emitting the light of the third color may be removed, and a first opening is disposed at a position of a removed first light emitting element, so as to expand a dimension of the first opening while ensuring a display effect. Among them, both N and n are positive integers. For example, n may be equal to N. However, the embodiment is not limited thereto. For example, n may be less than N or greater than N. In other examples, several first light emitting elements emitting the light of the first color or the light of the second color may be removed in the first display region, so as to expand the dimension of the first opening on a basis of ensuring a display resolution and a display effect.

FIG. 9 is another partial plan view of a display substrate according to at least one embodiment of the present disclosure. In some examples, as shown in FIG. 9, compared with a second pixel unit P within the second display region, a plurality of first light emitting elements emitting light of a third color (e.g., green light) within the first display region 100a are removed. For example, among a plurality of first pixel units within the first display region 100a, one first light emitting element emitting green light is removed, so that the plurality of first pixel units of the first display region 100a may be changed from an RGBG arrangement to an RGB arrangement. As shown in FIG. 9, a first pixel unit Q' within the first display region 100a may include three first light emitting elements (i.e., a first light emitting element Q1 that emits red light, a first light emitting element Q2 that emits blue light, and a first light emitting element Q3 that emits green light). In the example, a first opening 330 of a first cathode may be disposed at a position of a removed first light emitting element. For example, the first opening 330 may be disposed at intervals with a first light emitting element Q3 in a first direction X, and may be disposed at intervals with a first light emitting element Q3 in a second direction Y.

In some examples, as shown in FIG. 9, an orthographic projection of the first opening 330 on the base substrate may have a shape of a rectangle, such as a rounded rectangle. However, the embodiment is not limited thereto.

In some examples, a ratio of an area of a light emitting region of a first light emitting element within the first display region to an area of a light emitting region of a second light emitting element emitting light of a same color within the second display region may be about 45% to 50%, for example, may be about 50%.

In the example, although one first light emitting element in each first pixel unit is removed, a quantity of first pixel units is not reduced, a resolution of the first display region is not reduced, which has little effect on image quality of the first display region. Moreover, a region where a first light emitting element is removed is used for disposing a first opening, so that a dimension of the first opening of the first cathode may be widened. For example, taking the display substrate with 485 PPI of the example as an example, CD/Rib of an FMM used for patterning the first cathode of the first display region may be about 37 microns / 15 microns, which may meet a design requirement of the FMM.

In the example, a quantity of second light emitting elements included in one second pixel unit is greater than a quantity of first light emitting elements included in one first pixel unit. The second pixel unit may include four second light emitting elements, and the first pixel unit may include three first light emitting elements. A structure of the second pixel unit of the second display region of the display substrate in the example may be as described in the aforementioned embodiments, and will not be repeated here.

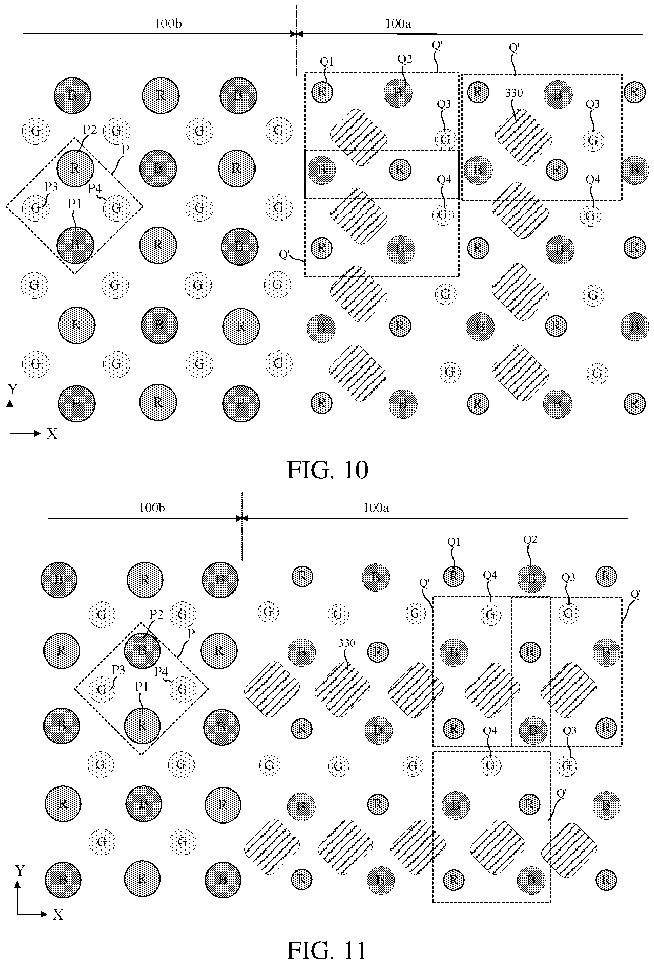

FIG. 10 is another partial plan view of a display substrate according to at least one embodiment of the present disclosure. In some examples, as shown in FIG. 10, a plurality of first light emitting elements emitting light of a third color (e.g., green light) within the first display region 100a may be removed. For example, by numbering columns of first light emitting elements emitting the light of the third color within the first display region, first light emitting elements emitting the light of the third color in a (2i+1)-th column or a 2i-th column within the first display region may be removed, where i is a positive integer, so that a column of first light emitting elements emitting the light of the third color is arranged every other two columns of first light emitting elements emitting light of a first color and light of a second color within the first display region. In the example, a first pixel unit Q' of the first display region 100a may include two first light emitting elements Q1 emitting the light of the first color, two first light emitting elements Q2 emitting the light of the second color, and one first light emitting element Q3 or Q4 emitting the light of the third color. First pixel units Q' may be arranged sequentially along a first direction X. In a second direction Y, two adjacent first pixel units Q' may share one first light emitting element Q1 and one first light emitting element Q2.

In the example, as shown in FIG. 10, a first opening 330 of a first cathode of the first display region 100a may be disposed at a position of a removed first light emitting element. For example, first openings 330 may be arranged adjacent along the second direction Y. A plurality of columns of first openings 330 may be arranged in the first display region 100a, and a first opening 330 may be disposed at intervals with a first light emitting element Q3 or Q4 that emits the light of the third color in the first direction X. In the example, a region where a first light emitting element is removed is used for disposing a first opening, so that a dimension of the first opening of the first cathode may be widened. With regard to rest of a structure of the display substrate of the embodiment, reference may be made to description of the above-mentioned embodiments, and will not be repeated here.

FIG. 11 is another partial plan view of a display substrate according to at least one embodiment of the present disclosure. In some examples, as shown in FIG. 11, a plurality of first light emitting elements emitting light of a third color (e.g., green light) within the first display region 100a may be removed. For example, by numbering rows of the first light emitting elements emitting the light of the third color within the first display region, first light emitting elements emitting the light of the third color in a (2i+1)-th row or a 2i-th row within the first display region may be removed, where i is a positive integer, so that a row of first light emitting elements emitting the light of the third color is arranged every other two rows of first light emitting elements emitting light of a first color and emitting light of a second color within the first display region. In the example, a first pixel unit Q' within the first display region 100a may include two first light emitting elements Q1 emitting the light of the first color, two first light emitting elements Q2 emitting the light of the second color, and one first light emitting element Q3 or Q4 emitting the light of the third color. First pixel units Q' may be arranged sequentially along the second direction Y. In the first direction X, two adjacent first pixel units Q' may share one first light emitting element Q1 and one first light emitting element Q2.

In the example, as shown in FIG. 11, a first opening 330 of a first cathode of the first display region 100a may be disposed at a position of a removed first light emitting element. For example, first openings 330 may be arranged adjacent along the first direction X. A plurality of rows of first openings 330 may be arranged in the first display region 100a, and a first opening 330 may be arranged at intervals with a first light emitting element Q3 or Q4 that emits the light of the third color in the second direction Y. In the example, a region where a first light emitting element is removed is used for disposing a first opening, so that a dimension of the first opening of the first cathode may be widened. With regard to rest of a structure of the display substrate of the embodiment, reference may be made to description of the above-mentioned embodiments, and will not be repeated here.

In other examples, a plurality of first light emitting elements within the first display region may be removed according to another rule. For example, one first light emitting element may be removed every other two first light emitting elements in each row of first light emitting elements emitting the light of the third color, or two first light emitting elements may be removed every other one first light emitting element in each column of first light emitting elements emitting the light of the third color. A rule of removing a first light emitting element emitting the light of the third color is not limited in the embodiment, as long as a display effect of the first display region is ensured. In some examples, after a plurality of first light emitting elements emitting the light of the third color are removed from the first display region, at least two adjacent first pixel units may share one first light emitting element emitting the light of the third color along the first direction X, or may share one first light emitting element emitting the light of the third color along the second direction Y.

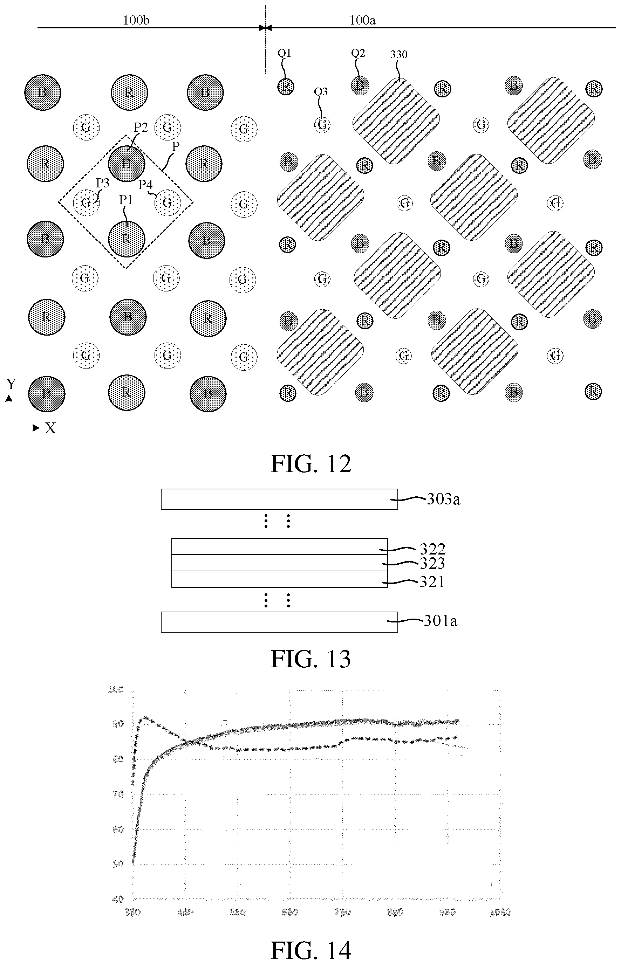

FIG. 12 is another partial plan view of a display substrate according to at least one embodiment of the present disclosure. In some examples, as shown in FIG. 12, a plurality of first light emitting elements emitting light of a third color (e.g., green light) within the first display region 100a may be removed. A first opening 330 of a first cathode may be disposed at a position of a removed first light emitting element. A structure of a first pixel unit within the first display region 100a and the position of the first opening may be referred to the embodiment shown in FIG. 9, and will not be repeated here.

In some examples, as shown in FIG. 12, a Tandem structure may be adopted for a first light emitting element of the first display region 100a. The light emitting element with the Tandem structure is an efficient light emitting device formed by a plurality of organic light emitting units connected in series and overlapped with each other.

FIG. 13 is a schematic diagram of a structure of a first light emitting element according to at least one embodiment of the present disclosure. In some examples, as shown in FIG. 13, the first light emitting element may include a first anode 301a, a first cathode 303a, and a first organic light emitting structure sandwiched between the first anode 301a and the first cathode 303a. The first organic light emitting structure may include at least two emitting layers (e.g., emitting layers 321 and 322), and a connection unit may be disposed between adjacent emitting layers. For example, a connection unit 323 may be disposed between the emitting layers 321 and 322. For example, a connection unit may include an electron transport layer and a hole transport layer. The connection unit may further include one or more of an electron injection layer, a connection layer, and a hole injection layer. The connection layer may also be referred to as a Charge Generation Layer (CGL). The connection layer may include an organic matter, and may further include a metal, a metal oxide, or an inorganic matter, etc. A function of the connection layer is to generate carriers, so that the electron injection layer or the electron transport layer can obtain electrons, and the hole injection layer or the hole transport layer can obtain holes. In some examples, a hole injection layer and a hole transport layer may be disposed between the first anode 301a and an adjacent emitting layer, and an electron injection layer and an electron transport layer may be disposed between the first cathode 303a and an adjacent emitting layer. For example, each emitting layer and an electron injection layer, an electron transport layer, a hole transport layer, and a hole injection layer which are adjacent to the emitting layer may constitute a complete organic light emitting unit. In some examples, a plurality of stacked emitting layers of a first light emitting element may be configured to emit light of a same color, thereby ensuring a display effect of the first display region. In some examples, a Tandem structure may not be adopted for a second light emitting element of a second display region. That is, a second organic light emitting structure of the second light emitting element may include one emitting layer.

In the example, a plurality of emitting layers are superposed in series by using connection units to form a Tandem structure, which may further reduce dimensions of a light emitting region and an anode of a first light emitting element of the first display region. For example, a ratio of an area of the light emitting region of the first light emitting element to an area of a light emitting region of a second light emitting element that emits light of a same color may be 10% to 50% (e.g., may be about 50%).

Taking the display substrate with 458 PPI of the example as an example, CD/Rib of an FMM used for patterning the first cathode of the first display region may be about 50 microns / 15 microns, which may meet a design requirement of the FMM.

FIG. 14 is a graph of a light transmittance of a connection layer of a first light emitting element according to at least one embodiment of the present disclosure. In FIG. 14, an abscissa represents a wavelength of light, and an ordinate represents a light transmittance. In FIG. 14, a dashed line shows a light transmittance curve of a Circular Polarizing Filter (CPL) for light with different wavelengths, and a solid line shows a light transmittance curve of the connection layer of the first light emitting element for light with different wavelengths. As shown in FIG. 14, the connection layer of the first light emitting element has little effect on a light transmittance of a first display region. In the example, a first light emitting element with a Tandem structure is adopted in the first display region, so that the light transmittance of the first display region may be ensured.

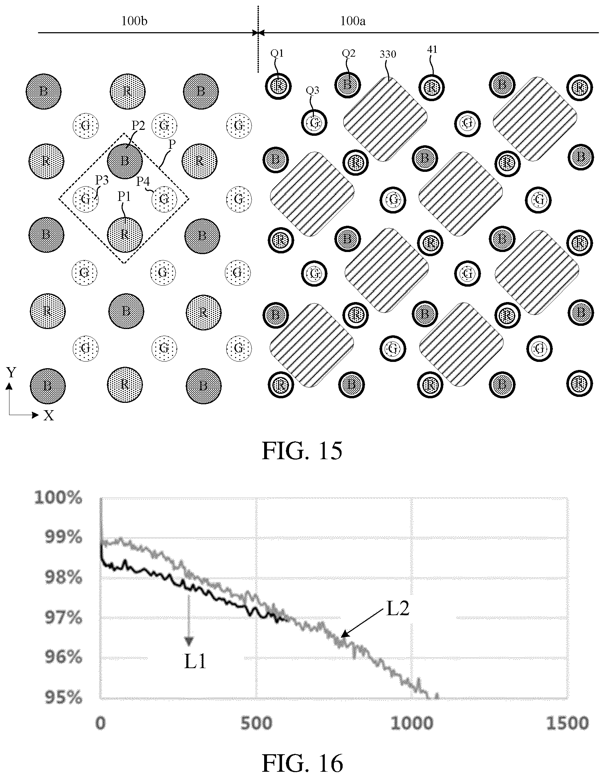

FIG. 15 is another partial plan view of a display substrate according to at least one embodiment of the present disclosure. In some examples, as shown in FIG. 15, in a first display region 100a, post spacers 41 may be disposed around a first light emitting element. For example, the post spacers 41 may be disposed surrounding the first light emitting element. A connection unit of the first light emitting element may be disconnected at a position of a post spacer 41. By disposing the post spacers 41, cross-talk between adjacent first light emitting elements may be reduced, thereby improving a display effect. However, an implementation mode of the post spacer is not limited in the example. In the example, the post spacers 41 have no effect on a light transmittance of the first display region 100a. With regard to rest of a structure of the display substrate of the embodiment, reference may be made to description of the above-mentioned embodiments, and will not be repeated here.

FIG. 16 is a schematic diagram of comparison between lifetime of a light emitting element with a Tandem structure and lifetime of a light emitting element including only a single emitting layer. In FIG. 16, an abscissa represents time in days, and an ordinate represents brightness. As shown in FIG. 16, a curve L1 represents a brightness variation curve with time of a light emitting element including only a single emitting layer, and a curve L2 represents a brightness variation curve with time of a light emitting element with a Tandem structure. As may be seen from FIG. 16, service life of the light emitting element with the Tandem structure may meet serve cycle for consumers based on service cycle (for example, about one to two years) of a conventional display product (for example, a mobile phone).

According to the display substrate provided in the example, the first light emitting element with the Tandem structure is adopted in the first display region, and an anode of the first light emitting element may be further reduced on a basis of ensuring a display effect, ensuring a light transmittance, and satisfying service life, so that a dimension of a first opening of a first cathode may be further increased.

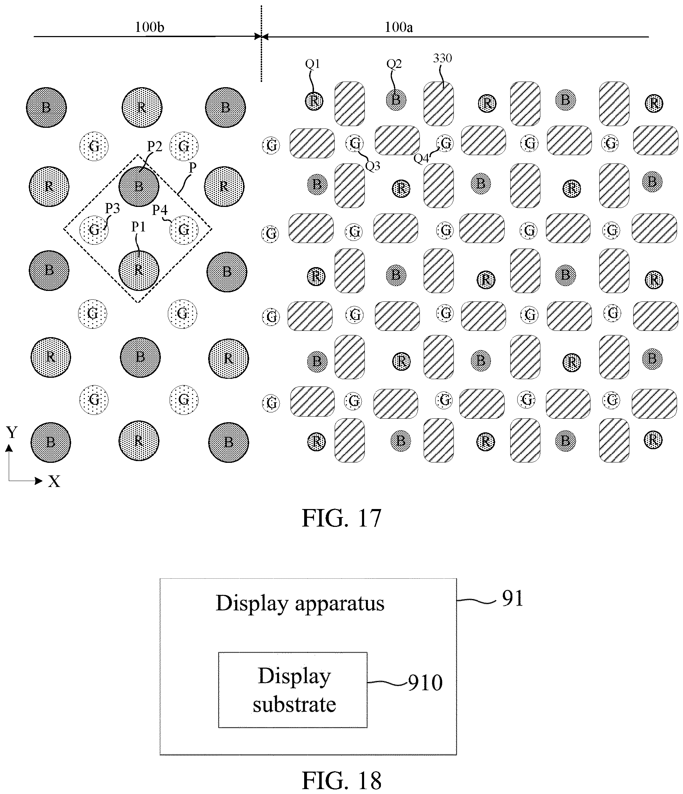

FIG. 17 is another partial plan view of a display substrate according to at least one embodiment of the present disclosure. In some examples, as shown in FIG. 17, a Tandem structure may be adopted for a first light emitting element within the first display region 100a. A first opening 330 of a first cathode may be disposed between adjacent first light emitting elements. First openings 330 may be disposed between adjacent first light emitting elements along a first direction X and a second direction Y, respectively. An orthographic projection of a first opening 330 on a base substrate may have a shape of a rectangle, such as a rounded rectangle.

In the example, the first light emitting element with the Tandem structure is adopted in the first display region, and an anode of the first light emitting element may be further reduced and a dimension of the first opening may be widened on a basis of ensuring a display effect, ensuring a light transmittance, and satisfying service life, thereby improving the light transmittance of the first display region and meeting design requirements of an FMM. With regard to rest of a structure of the display substrate of the embodiment, reference may be made to description of the above-mentioned embodiments, and will not be repeated here.

In other examples, the above-mentioned embodiments may be combined with each other. For example, on a basis of removing a part of first light emitting elements which emit the light of the third color in the first display region, positions of a plurality of first light emitting elements are adjusted to achieve concentration of the first light emitting elements, thereby further widening the dimension of the first opening. For another example, on a basis that the Tandem structure is adopted for the first light emitting element in the first display region, positions of a plurality of first light emitting elements are adjusted to achieve concentration of the first light emitting elements, thereby further widening the dimension of the first opening. However, the embodiment is not limited thereto.

FIG. 18 is a schematic diagram of a display apparatus according to at least one embodiment of the present disclosure. As shown in FIG. 18, the display apparatus 91 is provided in the embodiment, and includes a display substrate 910 of the aforementioned embodiments. In some examples, the display substrate 910 may be an OLED display substrate or a QLED display substrate. The display apparatus 91 may be any product or component with a display function, such as a mobile phone, a tablet computer, a television, a display, a laptop computer, a digital photo frame, and a navigator. However, the embodiment is not limited thereto.

The drawings of the present disclosure only involve structures involved in the present disclosure, and other structures may be referred to conventional designs. The embodiments of the present disclosure, i.e., features in the embodiments, may be combined with each other to obtain new embodiments if there is no conflict. Those of ordinary skills in the art should understand that modifications or equivalent replacements may be made to the technical solutions of the present disclosure without departing from the spirit and scope of the technical solutions of the present disclosure, and shall all fall within the scope of the claims of the present disclosure.

## Claims

1. A display substrate, comprising:
a base substrate, comprising a first display region and a second display region located on at least one side of the first display region;
a plurality of first pixel units located in the first display region, wherein a first pixel unit comprises a plurality of first light emitting elements, a first light emitting element comprises a first anode, a first organic light emitting structure, and a first cathode disposed sequentially along a direction away from the base substrate; the first cathode has a plurality of first openings, and orthographic projections of the first openings on the base substrate are not overlapped with an orthographic projection of a light emitting region of the first light emitting element on the base substrate; and
a plurality of second pixel units located in the second display region, wherein a second pixel unit comprises a plurality of second light emitting elements, a second light emitting element comprises a second anode, a second organic light emitting structure, and a second cathode disposed sequentially along the direction away from the base substrate;
a sum of areas of light emitting regions of first light emitting elements of the first display region is less than a sum of areas of light emitting regions of second light emitting elements of the second display region.

2. The display substrate according to claim 1, wherein a spacing between at least one first light emitting element and an adjacent first light emitting element within at least one of the plurality of first pixel units is less than a spacing between the first light emitting element and an adjacent first light emitting element within at least one adjacent first pixel unit.

3. The display substrate according to claim 1 or 2, wherein at least one first pixel unit shares at least one first light emitting element with an adjacent first pixel unit.

4. The display substrate according to claim 1 or 2, wherein at least one first pixel unit comprises only a plurality of first light emitting elements emitting light of different colors.

5. The display substrate according to any one of claims 1 to 4, wherein a first organic light emitting structure of at least one first light emitting element comprises at least a plurality of emitting layers stacked, wherein a connection unit is disposed between adjacent emitting layers.

6. The display substrate according to claim 5, wherein a post spacer is disposed around the first light emitting element and the connection unit is disconnected at a position of the post spacer.

7. The display substrate according to any one of claims 1 to 6, wherein the first openings are located between adjacent first pixel units.

8. The display substrate according to any one of claims 1 to 7, wherein the second cathode and the first cathode are of an integral structure.

9. The display substrate according to any one of claims 1 to 8, wherein a pixel center of at least one first pixel unit is different from a pixel center of the second pixel unit.

10. The display substrate according to any one of claims 1 to 9, wherein a spacing between at least one first light emitting element and an adjacent first light emitting element within at least one first pixel unit is less than a spacing between at least one second light emitting element and an adjacent second light emitting element within the second pixel unit; the first light emitting element and the second light emitting element emit light of a same color.

11. The display substrate according to claim 10, wherein the first pixel unit comprises one first light emitting element emitting light of a first color, one first light emitting element emitting light of a second color, and two first light emitting elements emitting light of a third color, and the four first light emitting elements comprised in the first pixel unit are arranged in a shape of a diamond;
the second pixel unit comprises one second light emitting element emitting light of the first color, one second light emitting element emitting light of the second color, and two second light emitting elements emitting light of the third color; and the four second light emitting elements comprised in the second pixel unit are arranged in a shape of a diamond;
a spacing between the first light emitting element emitting the light of the second color and an adjacent first light emitting element emitting light of the first color within the first pixel unit is less than a distance between the second light emitting element emitting the light of the second color and an adjacent second light emitting element emitting light of the first color within the second pixel unit.

12. The display substrate according to any one of claims 1 to 11, wherein a quantity of first light emitting elements comprised in the first pixel unit is different from a quantity of second light emitting elements comprised in the second pixel unit.

13. The display substrate according to claim 12, wherein the quantity of first light emitting elements comprised in the first pixel unit is less than the quantity of second light emitting elements comprised in the second pixel unit.

14. The display substrate according to claim 13, wherein the first pixel unit comprises one first light emitting element emitting light of a first color, one first light emitting element emitting light of a second color, and one first light emitting element emitting light of a third color;
the second pixel unit comprises one second light emitting element emitting light of the first color, one second light emitting element emitting light of the second color, and two second light emitting elements emitting light of the third color; and the four second light emitting elements comprised in the second pixel unit are arranged in a shape of a diamond.

15. The display substrate according to any one of claims 1 to 14, wherein an area of a light emitting region of the first light emitting element is less than an area of a light emitting region of a second light emitting element emitting light of a same color.

16. The display substrate according to claim 15, a ratio of the area of the light emitting region of the first light emitting element to the area of the light emitting region of the second light emitting element emitting the light of the same color is 10% to 50%.

17. The display substrate according to any one of claims 1 to 16, wherein the first openings are provided with a cathode patterning layer, and the cathode patterning layer is configured to prevent generation of the first cathode.

18. The display substrate according to claim 17, wherein a pixel definition layer is disposed within the first openings, and a hole injection layer, a hole transport layer, an electron transport layer, an electron injection layer, and a patterned cathode layer are disposed sequentially on a side of the pixel definition layer away from the base substrate.

19. A display apparatus, comprising a display substrate according to any one of claims 1 to 18.
